# EUROPEAN PATENT APPLICATION

(11) **EP 4 564 845 A1**
(43) Date of publication of application: **04.06.2025**
(21) Application number: 23896423.3
(22) Date of filing: 31.10.2023
(51) Int. Cl.: H04R 1/10

(54) **EARBUD STATE DETECTION METHOD, ELECTRONIC DEVICE, AND STORAGE MEDIUM**

(30) Priority: 30.11.2022 CN 202211523684; 30.12.2022 CN 202211730537
(71) Applicant: Huawei Technologies Co., Ltd., Shenzhen, Guangdong 518129 (CN)
(72) Inventor: TIAN, Yige, Shenzhen, Guangdong 518129 (CN)
(74) Representative: Grünecker Patent- und Rechtsanwälte PartG mbB
(86) International application number: PCT/CN2023/128766
(87) International publication number: WO 2024/114269

(57) **Abstract**

This application provides an earphone state detection method, an electronic device, and a storage medium. **In** the method, when an earphone event is detected, an earphone state is determined after a preset time period. The earphone event is an earphone out-of-case event or an earphone in-case event, the earphone out-of-case event represents that an earphone is in an out-of-case state, and the earphone in-case event represents that the earphone is in an in-case state. A user interface is displayed if the earphone state is the same as an earphone state represented by the earphone event. The user interface indicates the earphone state. **In** this application, the earphone can be accurately detected to be out of a case or in the case, so that an image showing that the earphone is out of the case or that the earphone is in the case can be accurately displayed, thereby improving user experience.

## Description

This application claims priority to Chinese Patent Application No. 202211523684.4, filed with the China National Intellectual Property Administration on November 30, 2022 and entitled "EARPHONE IN-CASE DETECTION METHOD AND DEVICE", and claims priority to Chinese Patent Application No. 202211730537.4, filed with the China National Intellectual Property Administration on December 30, 2022 and entitled "EARPHONE STATE DETECTION METHOD, ELECTRONIC DEVICE, AND STORAGE MEDIUM", which are incorporated herein by reference in their entireties.

### TECHNICAL FIELD

This application relates to the field of terminals, and in particular, to an earphone state detection method, an electronic device, and a storage medium.

### BACKGROUND

Currently, a wireless earphone may detect, by using a hardware device, that a cover is opened or closed and that the earphone is out of a case or in the case, for example, may detect, by using a Hall sensor, whether the earphone is out of the case or is in the case. However, some false detection is prone to occur when the hardware device is used for detection, leading to low detection accuracy. In addition, when false detection occurs, an image showing that the earphone is out of the case or that the earphone is in the case is incorrectly displayed on an electronic device of a user, bringing use inconvenience to the user.

### SUMMARY

This application provides an earphone state detection method, an electronic device, and a storage medium. On a basis of hardware device detection, software logic is added, so that false detection of the hardware device can be reduced, and accuracy of detecting that an earphone is out of a case or in the case can be improved.

According to a first aspect, an embodiment of this application provides an earphone state detection method. The method may be performed by an electronic device or a chip in the electronic device. The following uses the electronic device as an example for description. **In** the method, when detecting an earphone event, the electronic device may determine an earphone state after a preset time period. The earphone event is an earphone out-of-case event or an earphone in-case event, the earphone out-of-case event represents that an earphone is in an out-of-case state, and the earphone in-case event represents that the earphone is in an in-case state. The electronic device displays a user interface if the earphone state is the same as an earphone state represented by the earphone event. The user interface indicates the earphone state.

**In** this application, in a scenario in which the electronic device detects the earphone out-of-case event or the earphone in-case event, the electronic device may not immediately notify that the earphone is out of a case or in the case, but continues to detect the earphone state within the preset time period. This can ensure accuracy of the earphone state, and can avoid inaccurate displaying of the electronic device caused by an unstable earphone state in a short time.

On a basis of detecting that the earphone is out of the case or in the case by the Hall sensor, software logical judgment is added to filter out an abnormal signal triggered by hardware, so that accuracy of detecting that the earphone is out of the case or in the case is improved, to ensure that the user interface indicating that the earphone is out of the case or in the case is displayed after a cover of the electronic device is opened or closed and when the earphone is actually out of the case or in the case, thereby improving user experience.

In a possible implementation, the earphone out-of-case event is an out-of-case event of a single earphone or an out-of-case event of a plurality of earphones, the out-of-case event of the single earphone represents that the single earphone is in the out-of-case state, and the out-of-case event of the plurality of earphones represents that the plurality of earphones are in the out-of-case state. The earphone in-case event is an in-case event of the single earphone or an in-case event of the plurality of earphones, the in-case event of the single earphone represents that the single earphone is in the in-case state, and the in-case event of the plurality of earphones represents that the plurality of earphones are in the in-case state.

In this implementation, in a scenario in which the single earphone is out of the case or in the case, the electronic device may determine the earphone state again after the preset time period. When determining that the single earphone is out of the case or in the case, the electronic device may display the user interface indicating that the single earphone is out of the case or in the case. In a scenario in which the plurality of earphones are out of the case or in the case, the electronic device may determine the earphone state again after the preset time period. When determining that the plurality of earphones are out of the case or in the case, the electronic device may display a user interface indicating that the plurality of earphones are out of the case or in the case. **In** this implementation, the electronic device may display various user interfaces, so that displaying of the user interfaces can be enriched.

In a possible implementation, before detecting the earphone event, the electronic device further detects a cover opening event or a cover closing event. In this implementation, in a scenario in which a cover is opened or closed, the electronic device can ensure that the user interface indicating that the earphone is out of the case or in the case is displayed when the earphone is actually out of the case or in the case, thereby improving user experience.

In a possible implementation, the electronic device includes a first Hall sensor and a central processing unit CPU, and the first Hall sensor is configured to detect that the cover is opened or closed. A first Hall signal is sent to the CPU when the first Hall sensor detects that the cover is opened. The CPU generates the cover opening event based on the first Hall signal. A third Hall signal is sent to the CPU when the first Hall sensor detects that the cover is closed. The CPU generates the cover closing event based on the third Hall signal.

In a possible implementation, the electronic device further includes a second Hall sensor, a third Hall sensor, and a central processing unit CPU. The second Hall sensor and the third Hall sensor are configured to detect that the earphone is out of the case or in the case.

A second Hall signal is sent to the CPU when the second Hall sensor and the third Hall sensor detect that the earphone is out of the case. The CPU generates the earphone out-of-case event based on the second Hall signal. A fourth Hall signal is sent to the CPU when the second Hall sensor and the third Hall sensor detect that the earphone is in the case. The CPU generates the earphone in-case event based on the fourth Hall signal.

In a possible implementation, the CPU includes a sensor driver module, an earphone state detection module, and a user interface UI module; and generating the earphone out-of-case event includes: receiving, by the sensor driver module, the second Hall signal, and generating the earphone out-of-case event based on the second Hall signal.

Displaying the user interface includes: sending, by the sensor driver module, the earphone out-of-case event to the earphone state detection module; when receiving the earphone out-of-case event, sending, by the earphone state detection module, an earphone state query request to the sensor driver module after the preset time period, where the earphone state query request is used to request to query for the earphone state; sending, by the earphone state detection module, the earphone out-of-case event to the UI module if the found earphone state is still the earphone out-of-case state; and displaying, by the UI module, the user interface indicating that the earphone is out of the case.

In a possible implementation, the CPU includes a sensor driver module, an earphone state detection module, and a user interface UI module; and generating the earphone in-case event includes: receiving, by the sensor driver module, the fourth Hall signal, and generating the earphone in-case event based on the fourth Hall signal.

Displaying the user interface includes: sending, by the sensor driver module, the earphone in-case event to the earphone state detection module; when receiving the earphone in-case event, sending, by the earphone state detection module, an earphone state query request to the sensor driver module after the preset time period, where the earphone state query request is used to request to query for the earphone state; sending, by the earphone state detection module, the earphone in-case event to the UI module if the found earphone state is still the earphone in-case state; and displaying, by the UI module, the user interface indicating that the earphone is in the case.

In this implementation, modules in the electronic device may interact with each other, so that in a scenario in which the cover is opened or closed, the electronic device can ensure that the user interface indicating that the earphone is out of the case or in the case is displayed when the earphone is actually out of the case or in the case, thereby improving user experience.

According to a second aspect, an embodiment of this application provides an electronic device. The electronic device may include a processor and a memory. The memory is configured to store computer-executable program code. The program code includes instructions. When the processor executes the instructions, the instructions enable the electronic device to perform the method in the first aspect.

According to a third aspect, an embodiment of this application provides an electronic device. The electronic device may include a unit, a module, or a circuit configured to perform the method provided in the first aspect.

According to a fourth aspect, an embodiment of this application provides a computer program product including instructions. When the computer program product is run on a computer, the computer is enabled to perform the method in the first aspect.

According to a fifth aspect, an embodiment of this application provides a computer-readable storage medium. The computer-readable storage medium stores instructions, and when the instructions are run on a computer, the computer is enabled to perform the method in the first aspect.

For beneficial effects of the possible implementations of the second aspect to the fifth aspect, refer to the beneficial effects brought by the first aspect. Details are not described herein again.

Embodiments of this application provide an earphone state detection method, an electronic device, and a storage medium. In the method, when an earphone event is detected, an earphone state is determined after a preset time period. The earphone event is an earphone out-of-case event or an earphone in-case event, the earphone out-of-case event represents that an earphone is in an out-of-case state, and the earphone in-case event represents that the earphone is in an in-case state. A user interface is displayed if the earphone state is the same as an earphone state represented by the earphone event. The user interface indicates the earphone state. In this application, the earphone can be accurately detected to be out of a case or in the case, so that an image showing that the earphone is out of the case or that the earphone is in the case can be accurately displayed, thereby improving user experience.

### BRIEF DESCRIPTION OF DRAWINGS

FIG. 1 is a diagram of a hardware framework of an electronic device according to an embodiment of this application;
FIG. 2 is a diagram of a software framework of an electronic device according to an embodiment of this application;
FIG. 3 is a diagram showing that an electronic device incorrectly displays an earphone out-of-case animation according to an embodiment of this application;
FIG. 4 is diagram of a structure of an electronic device according to an embodiment of this application;
FIG. 5 is a diagram of signal transmission according to an embodiment of this application;
FIG. 6 is a schematic flowchart of an embodiment of an earphone state detection method according to an embodiment of this application;
FIG. 7 is a schematic flowchart of another embodiment of an earphone state detection method according to an embodiment of this application;
FIG. 8 is a schematic flowchart of another embodiment of an earphone state detection method according to an embodiment of this application; and
FIG. 9 is a schematic flowchart of another embodiment of an earphone state detection method according to an embodiment of this application.

### DESCRIPTION OF EMBODIMENTS

Terms used in the following embodiments of this application are merely intended to describe specific embodiments, but are not intended to limit this application. Terms "one", "a", "the", "the foregoing", "this", and "the one" of singular forms used in this specification and the appended claims of this application are also intended to include plural forms, unless otherwise specified in the context clearly. It should be further understood that the term "and/or" used in this application means and includes any or all possible combinations of one or more listed items.

The following describes an electronic device, a graphical user interface used for such an electronic device, and embodiments used for using such an electronic device. In some embodiments, the electronic device may be a portable electronic device that further includes another function such as a personal digital assistant function and/or a music player function, for example, a mobile phone, a tablet computer, or a wearable electronic device (for example, a smartwatch) having a wireless communication function. An example embodiment of a portable electronic device includes but is not limited to a portable electronic device using iOS^{®}, Android^{®}, Microsoft^{®}, or another operating system. The portable electronic device may alternatively be another portable electronic device, for example, a laptop (Laptop) having a touch-sensitive surface or a touch panel. It should be further understood that, in some other embodiments, the electronic device may alternatively be a desktop computer having a touch-sensitive surface or a touch panel, instead of the portable electronic device. A form of the electronic device is not limited in embodiments of this application.

The term "user interface (user interface, UI)" in the specification, claims, and accompanying drawings of this application is a medium interface for interaction and information exchange between a user and an application or an operating system, and implements conversion between an internal form of information and a form acceptable to the user. A user interface of an application is source code written by using a specific computer language such as a Java or extensible markup language (extensible markup language, XML). The interface source code is parsed and rendered on a terminal device, and finally is presented as content that can be identified by a user, for example, a control such as a picture, a text, or a button. A control (control), also referred to as a widget (widget), is a basic element of the user interface. Typical controls include a toolbar (toolbar), a menu bar (menu bar), a text box (text box), a button (button), a scroll bar (scroll bar), a picture, and a text. An attribute and content of a control in the interface are defined by using a tag or a node. For example, the control included in the interface is defined in the XML by using a node, for example, <Textview>, <ImgView>, or <VideoView>. One node corresponds to one control or one attribute in the interface. After being parsed and rendered, the node is presented as user-visible content. In addition, interfaces of many applications such as a hybrid application (hybrid application) usually further include a web page. A web page, also referred to as a page, may be understood as a special control embedded in an application interface. The web page is source code written in a specific computer language, for example, a hypertext markup language (hypertext markup language, HTML), cascading style sheets (cascading style sheets, CSS), or JavaScript (JavaScript, JS). The web page source code may be loaded and displayed, as content that can be identified by a user, by a browser or a web page display component with a function similar to that of the browser. Specific content included in the web page is also defined by using a tag or a node in the web page source code. For example, an element and an attribute of the web page are defined in the HTML by using <p>, <img>, <video>, and <canvas>.

The user interface is usually represented in a form of a graphical user interface (graphical user interface, GUI), and is a user interface that is related to a computer operation and that is displayed in a graphic manner. The user interface may be an interface element such as an icon, a window, or a control displayed on a display of the electronic device. The control may include a visual interface element such as an icon, a button, a menu, a tab, a text box, a dialog box, a status bar, a navigation bar, and a widget.

A wireless earphone may be used together with the electronic device, to process an audio service such as media and calls of the electronic device, as well as some other data services. For example, the audio service may include a service such as playing music, recording, and an incoming call prompt tone for a user, and may further include playing a voice from a peer end for the user, or collecting voice data of the user and sending the voice data to the peer end in a call service scenario such as a call, a voice message, an audio call, a video call, a game, or a voice assistant.

The wireless earphone is used together with the electronic device to provide various services for the user on the premise that the user takes the wireless earphone out of an earphone compartment that accommodates the wireless earphone. In an example, the earphone compartment for accommodating the wireless earphone may be disposed independently of the electronic device. For example, an earphone case may include the earphone compartment for accommodating the wireless earphone. In this example, the earphone case may detect that the earphone is out of the case and in the case, and the earphone case may send information to the electronic device, so that the electronic device determines that the earphone is out of the case and in the case. In an example, the electronic device may be provided with an earphone compartment that accommodates the wireless earphone. In this example, the electronic device may detect that the earphone is out of the case and in the case. In an example, the earphone being out of the case may also be referred to as the earphone being out of the compartment, and the earphone being in the case may also be referred to as the earphone being in the compartment.

For example, the electronic device may detect that the earphone is out of the case and is in the case. When the wireless earphone is out of the case, the electronic device needs to detect, in a timely manner, that the wireless earphone is out of the case, so that a related function of the wireless earphone can be enabled in a timely manner. Similarly, when the wireless earphone is in the case, the electronic device needs to detect, in a timely manner, that the wireless earphone is in the case. For example, the electronic device may disable a related function of the wireless earphone, to save power of the wireless earphone and charge the wireless earphone. It can be learned that out-of-case and in-case detection of the wireless earphone is particularly important for use of the wireless earphone.

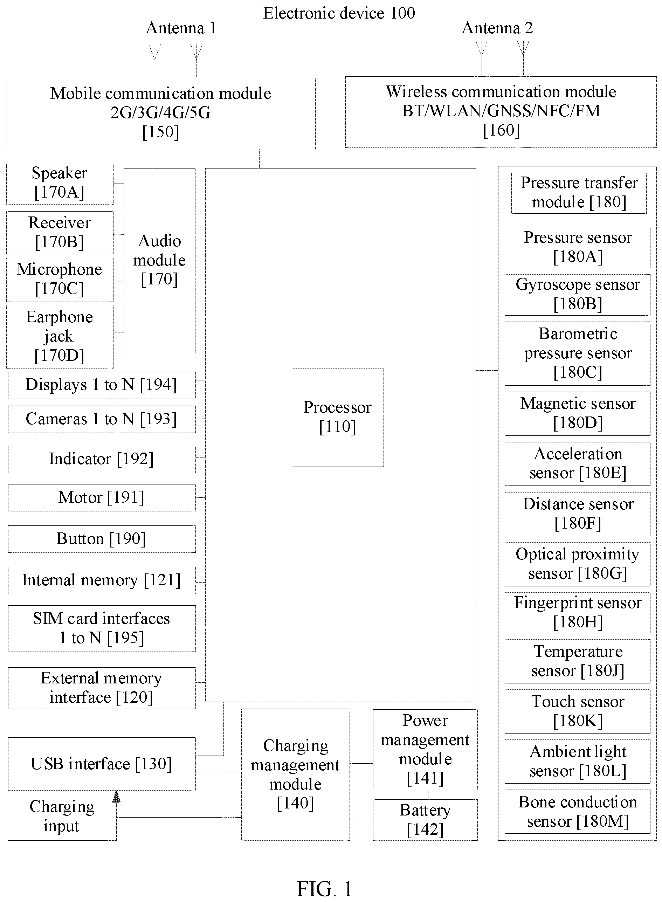

FIG. 1 is a diagram of a structure of an electronic device. As shown in FIG. 1, the electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, an earphone jack 170D, a sensor module 180, a button 190, a motor 191, an indicator 192, a display 194, and the like. The sensor module 180 may include a pressure sensor 180A, a gyroscope sensor 180B, an acceleration sensor 180E, a temperature sensor 180J, a touch sensor 180K, and the like.

It may be understood that the structure shown in this embodiment of this application does not constitute a specific limitation on the electronic device 100. In some other embodiments of this application, the electronic device 100 may include more or fewer components than those shown in the figure, or some components may be combined, or some components may be split, or different component arrangements may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, a neural-network processing unit (neural-network processing unit, NPU), and/or the like. Different processing units may be independent components, or may be integrated into one or more processors. In some embodiments, the electronic device 100 may alternatively include one or more processors 110.

The controller may be a nerve center and a command center of the electronic device 100. The controller may generate an operation control signal based on instruction operation code and a time sequence signal, to complete control of instruction fetching and instruction execution.

A memory may be further disposed in the processor 110, and is configured to store instructions and data. In some embodiments, the memory in the processor 110 is a cache memory. The memory may store instructions or data just used or cyclically used by the processor 110. If the processor 110 needs to use the instructions or the data again, the processor may directly invoke the instructions or the data from the memory. This avoids repeated access and reduces waiting time of the processor 110, thereby improving efficiency of the electronic device 100.

In some embodiments, the processor 110 may be configured to execute instructions in the internal memory 121, and invoke a related module to implement the earphone state detection method in embodiments of this application. In addition, for example, the processor may further execute instructions in the internal memory 121, to implement a charging function, a wireless communication function, an audio data playing function, and the like of the wireless earphone.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

In some embodiments, the processor 110 may be connected to the wireless earphone through at least one of the one or more interfaces. In this embodiment of this application, an example in which the processor 110 is connected to the wireless earphone through the GPIO interface is used for description.

The I2C interface is a bidirectional synchronous serial bus, including a serial data line (serial data line, SDA) and a serial clock line (serial clock line, SCL). In some embodiments, the processor 110 may include a plurality of groups of I2C buses. The processor 110 may be separately coupled to the touch sensor 180K, a charger, a flash, the camera 193, and the like through different I2C bus interfaces. For example, the processor 110 may be coupled to the touch sensor 180K through the I2C interface, so that the processor 110 communicates with the touch sensor 180K through the I2C bus interface, to implement a touch function of the electronic device 100.

The I2S interface may be configured to perform audio communication. In some embodiments, the processor 110 may include a plurality of groups of I2S buses. The processor 110 may be coupled to the audio module 170 through the I2S bus, to implement communication between the processor 110 and the audio module 170. In some embodiments, the audio module 170 may transmit an audio signal to the wireless communication module 160 through the I2S interface, to implement a function of answering a call through a Bluetooth earphone.

The PCM interface may also be used to perform audio communication, and sample, quantize, and code an analog signal. In some embodiments, the audio module 170 may be coupled to the wireless communication module 160 through a PCM bus interface. In some embodiments, the audio module 170 may also transmit an audio signal to the wireless communication module 160 through the PCM interface, to implement a function of answering a call through a Bluetooth earphone. Both the I2S interface and the PCM interface may be used for audio communication.

The UART interface is a universal serial data bus, and is configured to perform asynchronous communication. The bus may be a bidirectional communication bus. The bus converts to-be-transmitted data between serial communication and parallel communication. In some embodiments, the UART interface is usually configured to connect the processor 110 to the wireless communication module 160. For example, the processor 110 communicates with a Bluetooth module in the wireless communication module 160 through the UART interface, to implement a Bluetooth function. In some embodiments, the audio module 170 may transmit an audio signal to the wireless communication module 160 through the UART interface, to implement a function of playing music through a Bluetooth earphone.

The MIPI interface may be configured to connect the processor 110 to a peripheral component such as the display 194 or the camera 193. The MIPI interface includes a camera serial interface (camera serial interface, CSI), a display serial interface (display serial interface, DSI), and the like. In some embodiments, the processor 110 communicates with the camera 193 through the CSI interface, to implement a photographing function of the electronic device 100. The processor 110 communicates with the display 194 through the DSI interface, to implement a display function of the electronic device 100.

The GPIO interface may be configured by software. The GPIO interface may be configured as a control signal or a data signal. In some embodiments, the GPIO interface may be configured to connect the processor 110 to the camera 193, the display 194, the wireless communication module 160, the audio module 170, the sensor module 180, and the like. The GPIO interface may alternatively be configured as an I2C interface, an I2S interface, a UART interface, an MIPI interface, and the like.

The USB interface 130 is an interface that conforms to a USB standard specification, and may be specifically a mini USB interface, a micro USB interface, a USB type-C interface, and the like. The USB interface 130 may be configured to connect to a charger to charge the electronic device 100, or may be configured to transmit data between the electronic device 100 and a peripheral device, or may be configured to connect to an earphone for playing audio through the earphone. The interface may be further configured to connect to another electronic device such as an AR device.

It may be understood that an interface connection relationship between the modules illustrated in this embodiment of this application is merely an illustrative description, and does not constitute a limitation on the structure of the electronic device 100. In some other embodiments, the electronic device 100 may alternatively use an interface connection manner different from that in the foregoing embodiment, or use a combination of a plurality of interface connection manners.

The charging management module 140 is configured to receive a charging input from a charger. The charger may be a wireless charger or a wired charger. In some embodiments of wired charging, the charging management module 140 may receive a charging input of the wired charger through the USB interface 130. In some embodiments of wireless charging, the charging management module 140 may receive a wireless charging input through a wireless charging coil of the electronic device 100. The charging management module 140 supplies power to the electronic device through the power management module 141 while charging the battery 142.

The power management module 141 is configured to connect to the battery 142, the charging management module 140, and the processor 110. The power management module 141 receives an input from the battery 142 and/or the charging management module 140, to supply power to the processor 110, the internal memory 121, an external memory, the display 194, the camera 193, the wireless communication module 160, and the like. The power management module 141 may be further configured to monitor parameters such as a battery capacity, a quantity of battery cycles, and a battery state of health (electric leakage or impedance). In some other embodiments, the power management module 141 may alternatively be disposed in the processor 110. In some other embodiments, the power management module 141 and the charging management module 140 may alternatively be disposed in a same device.

A wireless communication function of the electronic device 100 may be implemented through the antenna 1, the antenna 2, the mobile communication module 150, the wireless communication module 160, the modem processor, the baseband processor, and the like.

The antenna 1 and the antenna 2 are configured to transmit and receive an electromagnetic wave signal. Each antenna in the electronic device 100 may be configured to cover one or more communication frequency bands. Different antennas may be further multiplexed, to improve antenna utilization. For example, the antenna 1 may be multiplexed as a diversity antenna of a wireless local area network. In some other embodiments, the antenna may be used in combination with a tuning switch.

The mobile communication module 150 may provide a wireless communication solution that is applied to the electronic device 100 and that includes a 2G/3G/4G/5G or the like. The mobile communication module 150 may include at least one filter, a switch, a power amplifier, a low noise amplifier (low noise amplifier, LNA), and the like. The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the amplified signal into an electromagnetic wave for radiation through the antenna. In some embodiments, at least some functional modules in the mobile communication module 150 may be disposed in the processor 110. In some embodiments, at least some functional modules of the mobile communication module 150 may be disposed in a same device as at least some modules of the processor 110.

The modem processor may include a modulator and a demodulator. The modulator is configured to modulate a to-be-sent low-frequency baseband signal into a medium-high frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal by an audio device (which is not limited to the speaker 170A, the receiver 170B, or the like), or displays an image or a video by the display 194. In some embodiments, the modem processor may be an independent component. In some other embodiments, the modem processor may be independent of the processor 110, and is disposed in a same device as the mobile communication module 150 or another functional module.

The wireless communication module 160 may provide a wireless communication solution that is applied to the electronic device 100 and that includes a wireless local area network (wireless local area networks, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, ultra-wideband (UWB), or the like. The wireless communication module 160 may be one or more components integrating at least one communication processor module. The wireless communication module 160 receives an electromagnetic wave through an antenna, performs frequency modulation and filtering processing on the electromagnetic wave signal, and sends the processed signal to the processor 110. The wireless communication module 160 may further receive a to-be-sent signal from the processor 110, perform frequency modulation and amplification on the signal, and convert the signal into an electromagnetic wave through for radiation the antenna. For example, the wireless communication module 160 may include a Bluetooth module, a Wi-Fi module, and the like.

In some embodiments, a part of the antennas of the electronic device 100 is coupled to the mobile communication module 150, and the other part of the antennas is coupled to the wireless communication module 160, so that the electronic device 100 can communicate with a network and another device by using a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), a millimeter wave (mmWave), BT, a GNSS, a WLAN, NFC, FM, UWB, an IR technology, and/or the like. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite based augmentation system (satellite based augmentation systems, SBAS).

The electronic device 100 may implement a display function through the GPU, the display 194, the application processor, and the like. The GPU is a microprocessor for image processing, and is connected to the display 194 and the application processor. The GPU is configured to perform mathematical and geometric computation, and render an image. The processor 110 may include one or more GPUs that execute instructions to generate or change display information.

The display 194 is configured to display an image, a video, and the like. The display 194 includes a display panel. The display panel may be a liquid crystal display (liquid crystal display, LCD), an organic light-emitting diode (organic light-emitting diode, OLED), an active-matrix organic light emitting diode (active-matrix organic light emitting diode, AMOLED), a flexible light-emitting diode (flexible light-emitting diode, FLED), a mini-LED, a micro-LED, a micro-OLED, a quantum dot light emitting diode (quantum dot light emitting diodes, QLED), or the like. In some embodiments, the electronic device 100 may include one or N displays 194, where N is a positive integer greater than 1.

The digital signal processor is configured to process a digital signal, and may process another digital signal in addition to the digital image signal. For example, when the electronic device 100 selects a frequency, the digital signal processor is configured to perform Fourier transformation or the like on frequency energy.

The video codec is configured to compress or decompress a digital video. The electronic device 100 may support one or more video codecs. In this way, the electronic device 100 may play or record videos in a plurality of coding formats, for example, moving picture experts group (moving picture experts group, MPEG)-1, MPEG-2, MPEG-3, and MPEG-4.

The NPU is a neural-network (neural-network, NN) computing processor, quickly processes input information by referring to a structure of a biological neural network, for example, by referring to a transfer mode between human brain neurons, and may further continuously perform self learning. Applications such as intelligent cognition of the electronic device 100, for example, image recognition, facial recognition, speech recognition, and text understanding, may be implemented through the NPU.

The external memory interface 120 may be used to connect to an external memory card, for example, a micro SD card, to extend a storage capability of the electronic device 100. The external memory card communicates with the processor 110 through the external memory interface 120, to implement a data storage function. For example, data such as music, a photo, and a video is stored in the external memory card.

The internal memory 121 may be configured to store one or more computer programs. The one or more computer programs include instructions. The processor 110 may run the instructions stored in the internal memory 121, so that the electronic device 100 performs the earphone state detection method provided in embodiments of this application, various function applications, data processing, and the like. For example, the internal memory 121 may include program code and the like for performing wireless pairing and connection between the wireless earphone and the electronic device 100, to perform wireless communication. The memory 302 may further store a Bluetooth address used to uniquely identify the wireless earphone. In addition, the memory 302 may further store connection data of an electronic device successfully paired with the wireless earphone before. For example, the connection data may be a Bluetooth address of the electronic device successfully paired with the wireless earphone. Based on the connection data, the wireless earphone can be automatically paired with the electronic device, and a connection between the wireless earphone and the electronic device does not need to be configured. For example, validity verification is not required. The Bluetooth address may be a media access control (media access control, MAC) address.

In addition, the internal memory 121 may include a high-speed random access memory, or may include a non-volatile memory, for example, at least one magnetic disk storage device, a flash memory device, or universal flash storage (universal flash storage, UFS).

The electronic device 100 may implement an audio function, for example, music playing and recording, by using the audio module 170, the speaker 170A, the receiver 170B, the microphone 170C, the earphone jack 170D, the application processor, and the like.

The audio module 170 is configured to convert digital audio information into an analog audio signal output, and is also configured to convert an analog audio input into a digital audio signal. The audio module 170 may be further configured to code and decode an audio signal. In some embodiments, the audio module 170 may be disposed in the processor 110, or some functional modules in the audio module 170 are disposed in the processor 110.

The speaker 170A, also referred to as a "loudspeaker", is configured to convert an audio electrical signal into a sound signal. The electronic device 100 may be used to listen to music or answer a call in a hands-free mode over the speaker 170A.

The receiver 170B, also referred to as an "earpiece", is configured to convert an audio electrical signal into a sound signal. When a call is answered or a voice message is received on the electronic device 100, the receiver 170B may be put close to a human ear to listen to a voice.

The microphone 170C, also referred to as a "mike" or a "mic", is configured to convert a sound signal into an electrical signal. When making a call or sending a voice message, a user may make a sound near the microphone 170C through the mouth of the user, to input a sound signal to the microphone 170C. At least one microphone 170C may be disposed in the electronic device 100. In some other embodiments, two microphones 170C may be disposed in the electronic device 100, to implement a noise reduction function, in addition to collecting a sound signal. In some other embodiments, three, four, or more microphones 170C may alternatively be disposed in the electronic device 100, to collect a sound signal, implement noise reduction, and identify a sound source, to implement a directional recording function and the like.

The earphone jack 170D is configured to connect to a wired earphone. The earphone jack 170D may be a USB interface 130, or may be a 3.5 mm open mobile terminal platform (open mobile terminal platform, OMTP) standard interface or cellular telecommunications industry association of the USA (cellular telecommunications industry association of the USA, CTIA) standard interface.

The pressure sensor 180A is configured to sense a pressure signal, and can convert the pressure signal into an electrical signal. In some embodiments, the pressure sensor 180A may be disposed in the display 194. There are a plurality of types of pressure sensors 180A, such as a resistive pressure sensor, an inductive pressure sensor, and a capacitive pressure sensor. The capacitive pressure sensor may include at least two parallel plates made of conductive materials. When a force is applied to the pressure sensor 180A, a capacitance between electrodes changes. The electronic device 100 determines a pressure strength based on the change in the capacitance. When a touch operation is performed on the display 194, the electronic device 100 detects a strength of the touch operation by using the pressure sensor 180A. The electronic device 100 may also calculate a touch location based on a detection signal of the pressure sensor 180A. In some embodiments, touch operations that are performed in a same touch position but have different touch operation strengths may correspond to different operation instructions. For example, when a touch operation with a touch operation strength less than a first pressure threshold is performed on a Messages icon, an instruction for viewing an SMS message is executed. When a touch operation with a touch operation strength greater than or equal to the first pressure threshold is performed on the Messages icon, an instruction for creating a new SMS message is executed.

The gyroscope sensor 180B may be configured to determine a motion gesture of the electronic device 100. In some embodiments, angular velocities of the electronic device 100 around three axes (namely, x, y, and z axes) may be determined by using the gyroscope sensor 180B. The gyroscope sensor 180B may be configured to implement image stabilization during photographing. For example, when a shutter is pressed, the gyroscope sensor 180B detects an angle at which the electronic device 100 jitters; calculates, based on the angle, a distance for which a lens module needs to compensate; and enables the lens to cancel the jitter of the electronic device 100 through reverse motion, to implement image stabilization. The gyroscope sensor 180B may further be used in a navigation scenario and a somatic game scenario.

The magnetic sensor 180D may include but is not limited to a Hall sensor, a magnetometer, and the like. In some embodiments, the magnetic sensor 180D is configured to detect a magnetic induction strength of a magnetic field around the electronic device 100. For example, the processor 110 may perform the method in embodiments of this application, to detect that the wireless earphone is out of a case or in the case based on a change of a magnetic induction strength detected by the magnetic sensor.

In some embodiments, the electronic device 100 may detect opening and closing of a flip leather case by using the magnetic sensor 180D. In some embodiments, when the electronic device 100 is a flip phone, the electronic device 100 may detect opening and closing of a flip cover by using the magnetic sensor 180D. Further, a feature such as automatic unlocking of the flip cover is set based on a detected open/closed state of the leather case or a detected open/closed state of the flip cover.

The acceleration sensor 180E may detect accelerations in various directions (usually on three axes) of the electronic device 100. When the electronic device 100 is still, a magnitude and a direction of gravity may be detected. The acceleration sensor 180E may be further configured to identify a posture of the electronic device, and is used in an application such as switching between a landscape mode and a portrait mode or a pedometer.

The touch sensor 180K may also be referred to as a touch panel or a touch-sensitive surface. The touch sensor 180K may be disposed in the display 194, and the touch sensor 180K and the display 194 constitute a touchscreen, which is also referred to as a "touch screen". The touch sensor 180K is configured to detect a touch operation on or near the touch sensor 180K. The touch sensor may transfer the detected touch operation to the application processor to determine a type of a touch event. A visual output related to the touch operation may be provided through the display 194. In some other embodiments, the touch sensor 180K may also be disposed on a surface of the electronic device 100 at a location different from that of the display 194.

The button 190 includes a power button, a volume button, and the like. The button 190 may be a mechanical button, or may be a touch-sensitive button. The electronic device 100 may receive a button input, and generate a button signal input related to user setting and function control of the electronic device 100.

The motor 191 may generate a vibration prompt. The motor 191 may be configured to provide an incoming call vibration prompt and a touch vibration feedback. For example, touch operations performed on different applications (such as a photographing application and an audio playing application) may correspond to different vibration feedback effect. The motor 191 may also correspond to different vibration feedback effect for touch operations performed on different areas of the display 194. Different application scenarios (for example, a time reminder, information receiving, an alarm clock, and a game) may also correspond to different vibration feedback effect. Touch vibration feedback effect may be further customized.

The indicator 192 may be an indicator light, and may be configured to indicate a charging status and a power change, or may be configured to indicate a message, a missed call, a notification, and the like.

The electronic device 100 shown in FIG. 1 as an example may display, by using the display 194, graphical user interfaces described in the following embodiments. The electronic device 100 may detect a touch operation on the graphical user interfaces by using the touch sensor 180K, for example, a tap operation (for example, a touch operation or a double-tap operation on an icon) on the graphical user interfaces, or an upward or downward swipe operation or an operation of drawing a circle gesture on the graphical user interfaces. In some embodiments, the electronic device 100 may detect, by using the gyroscope sensor 180B, the acceleration sensor 180E, or the like, a motion gesture performed by the user holding the electronic device 100, for example, shaking the electronic device. In some embodiments, the electronic device 100 may detect a non-touch gesture operation by using the camera 193 (such as a 3D camera or a depth camera).

In some embodiments, the wireless earphone in this application may include a processor, a memory, a communication module, an audio module, a power module, a plurality of input/output interfaces, a sensor module, and the like. For the processor, the memory, the communication module, the audio module, the power module, and the plurality of input/output interfaces, refer to related descriptions of corresponding modules in the electronic device.

In some embodiments, the sensor module in the wireless earphone may include but is not limited to a distance sensor and/or an optical proximity sensor. The processor in the wireless earphone may determine, based on data acquired by the distance sensor, whether the wireless earphone is worn by the user. For example, the processor may detect, by using the data acquired by the distance sensor, whether there is an object near the wireless earphone, to determine whether the wireless earphone is worn by the user. When determining that the wireless earphone is worn, for example, the processor may turn on the speaker of the wireless earphone.

In some embodiments, the wireless earphone may further include a bone conduction sensor, to be integrated into a bone conduction earphone. By using the bone conduction sensor, the processor in the wireless earphone may obtain a vibration signal of a vibration bone block of a vocal-cord part, and parse out a voice signal, to implement a voice function. For another example, an outer surface of the wireless earphone may further include a touch sensor, configured to detect a touch operation of the user. The fingerprint sensor is configured to detect a user fingerprint, identify a user identity, and the like.

In some embodiments, the wireless earphone may further include an ambient light sensor, and the ambient light sensor may adaptively adjust some parameters (for example, a volume) based on perceived luminance of ambient light.

A software system of the electronic device 100 may use a layered architecture, an event-driven architecture, a microkernel architecture, a micro service architecture, or a cloud architecture. In this embodiment of this application, an Android system with a layered architecture is used as an example to describe a software structure of the electronic device 100.

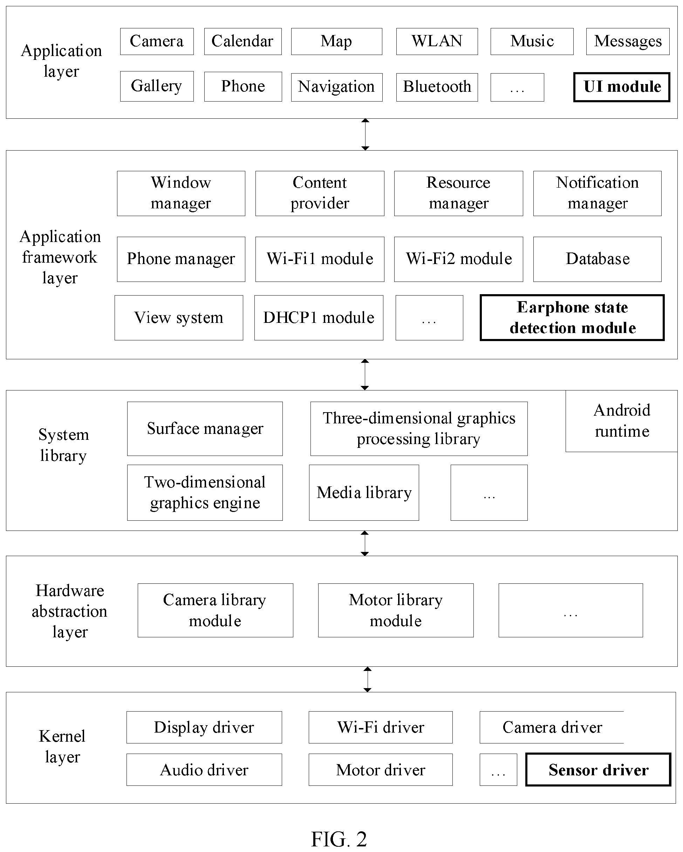

FIG. 2 is a block diagram of a software structure of an electronic device according to an embodiment of this application. In a layered architecture, software is divided into several layers, and each layer has a clear role and task. The layers communicate with each other through a software interface. In some embodiments, the Android system is divided into four layers: an application layer, an application framework layer, an Android runtime (Android runtime) and system library layer, and a kernel layer from top to bottom.

The application layer may include a series of application packages. As shown in FIG. 2, the application packages may include applications such as Camera, Gallery, Calendar, Call, Map, Navigation, WLAN, Bluetooth, Music, Videos, and Messages.

In some embodiments, with reference to FIG. 2, the application layer may include a UI module, and the UI module is used to draw a user interface representing that an earphone is out of a case or in the case.

The application framework layer provides an application programming interface (application programming interface, API) and a programming framework for an application at the application layer. The application framework layer includes some predefined functions.

As shown in FIG. 2, the application framework layer may include a window manager, a content provider, a view system, a phone manager, a resource manager, a notification manager, a camera manager, an audio manager, and the like.

The window manager is used to manage a window program. The window manager may obtain a size of the display, determine whether there is a status bar, perform screen locking, take a screenshot, and the like.

The content provider is used to store and obtain data, and enables these data to be accessible to an application. The data may include a video, an image, an audio, calls that are made and answered, a browsing history and bookmarks, an address book, and the like.

The view system includes visual controls such as a control for displaying a text and a control for displaying an image. The view system may be used to construct an application. A display interface may include one or more views. For example, a display interface including an SMS message notification icon may include a text display view and an image display view.

The phone manager is used to provide a communication function of the electronic device 100, for example, management of a call status (including answering, declining, and the like).

The resource manager provides an application with various resources, such as a localized character string, an icon, a picture, a layout file, and a video file.

The notification manager enables an application to display notification information in a status bar, and may be used to convey a notification-type message. The displayed notification information may automatically disappear after a short pause without user interaction. For example, the notification manager is used to notify download completion, provide a message notification, and the like. The notification manager may alternatively be a notification that appears in a top status bar of the system in a form of a graph or a scroll bar text, for example, a notification of an application that is run on a background, or may be a notification that appears on the screen in a form of a dialog window. For example, text information is displayed in the status bar, an announcement is given, the electronic device vibrates, or an indicator light blinks.

The camera manager is used to manage a status of one or more cameras. When a camera is used or released, the camera manager can notify a use or release event and a corresponding camera ID.

The audio manager is used to manage audio settings and audio-related hardware, such as a microphone and a speaker. The audio manager can be used to control settings such as an audio mode and volume, and monitor use or release of a hardware resource such as the microphone or the speaker.

In some embodiments, with reference to FIG. 2, the application framework layer may include an earphone state detection module. The earphone state detection module is configured to detect an earphone state, and interact with the UI module based on the earphone state. The earphone state may include an out-of-case state and an in-case state.

The Android runtime includes a kernel library and a virtual machine. The Android runtime is responsible for scheduling and management of the Android system.

The kernel library includes two parts: a function that needs to be called in a Java language and a kernel library of Android.

The application layer and the application framework layer run on the virtual machine. The virtual machine executes Java files at the application layer and the application framework layer as binary files. The virtual machine is used to perform functions such as object lifecycle management, stack management, thread management, security and exception management, and garbage collection.

The system library may include a plurality of functional modules, for example, a surface manager (surface manager), a media library (Media Libraries), a three-dimensional graphics processing library (for example, an OpenGL ES), and a 2D graphics engine (for example, an SGL).

The surface manager is used to manage a display subsystem and provide fusion of 2D and 3D layers for a plurality of applications.

The media library supports playback and recording in a plurality of commonly used audio and video formats, and static image files. The media library may support a plurality of audio and video coding formats such as MPEG-4, H.264, MP3, AAC, AMR, JPG, and PNG.

The three-dimensional graphics processing library is used to implement three-dimensional graphics drawing, image rendering, composition, layer processing, and the like.

The 2D graphics engine is a drawing engine for 2D drawing.

The kernel layer is a layer between hardware and software. The kernel layer includes at least a display driver, a camera driver, an audio driver, and a sensor driver. In an example, the sensor driver may include a Hall sensor driver or a magnetometer driver.

The software system shown in FIG. 2 relates to application presentation (such as gallery and file management) that uses a sharing capability, a directional sharing module that provides a sharing capability, an application framework layer that provides a WLAN service and a Bluetooth service, and a kernel and a bottom layer that provide a WLAN Bluetooth capability and a basic communication protocol.

The following describes an example of a working process of software and hardware of the electronic device 100 with reference to a photo capturing scenario.

When the touch sensor 180K receives a touch operation, a corresponding hardware interrupt is sent to the kernel layer. The kernel layer processes the touch operation into an original input event (including information such as touch coordinates and a time stamp of the touch operation). The original input event is stored at the kernel layer. The application framework layer obtains the original input event from the kernel layer, and identifies a control corresponding to the input event. An example in which the touch operation is a touch operation and a control corresponding to the touch operation is a control of a camera application icon is used. A camera application invokes an interface of the application framework layer to start the camera application, then starts the camera driver by invoking the kernel layer, and captures a static image or a video by using the camera 193.

This application provides a wireless earphone and an accommodating apparatus thereof, where the accommodating apparatus is configured to accommodate the wireless earphone. In embodiments of this application, the accommodating apparatus may be an electronic device, and the wireless earphone may be a single earphone or two earphones. The wireless earphone may be specifically an earplug earphone, an ear-mounted earphone, an in-ear earphone, or the like. For example, the wireless earphone may be a true wireless stereo (true wireless stereo, TWS) earphone. A form of the wireless earphone is not limited in embodiments of this application.

An example in which the wireless earphone is two earphones is used, and the accommodating apparatus may include an upper cover and an earphone compartment. The upper cover and the earphone compartment may be rotatably connected to each other. The earphone compartment is provided with accommodating cavities, to accommodate the earphones. The upper cover is provided with a magnetic apparatus, and a position of the magnetic apparatus corresponds to positions of the accommodating cavities. The earphones include magnetic materials, so that the earphones can be attached by the magnetic apparatus.

During use, when the earphones are in the accommodating cavities of the earphone compartment, the magnetic apparatus of the upper cover can attach the earphones. When the upper cover is opened, the earphones can be attached to the upper cover, and are detached from the accommodating cavities with movement of the upper cover. The user may remove the earphones from the upper cover for use. After use, the user may place the earphones at corresponding positions in the upper cover and snap-fit the upper cover. When the upper cover moves close to the earphone compartment, the earphones may enter the accommodating cavities. **In** this embodiment of this application, that the earphones are out of a case means that the earphones are out of the earphone compartment, and that the earphones are in the case means that the earphones are in the earphone compartment.

In some embodiments, the accommodating apparatus may be a wearable device, for example, a smartwatch, and a built-in earphone compartment of the wearable device can accommodate the wireless earphones. The upper cover is provided with a display, and the earphone compartment includes devices such as a processor and a circuit board. The upper cover and the earphone compartment may be electrically connected to each other through a connection apparatus. When the upper cover is snap-fitted to the earphone compartment, the upper cover and the earphone compartment can be used together as a smartwatch.

The accommodating apparatus may include a Hall sensor. During an out-of-case or in-case process of the earphones, the Hall sensor is configured to detect that the earphones are out of the case or in the case and that the cover is opened or closed. That the cover is opened or closed may be understood as that the upper cover of the electronic device is opened or closed. Specifically, the accommodating apparatus may include at least three Hall sensors, namely, a first Hall sensor, a second Hall sensor, and a third Hall sensor respectively. The first Hall sensor is configured to detect that the cover is opened or closed, and the second Hall sensor and the third Hall sensor are configured to detect that left and right earphones are out of the case or in the case.

In some embodiments, the upper cover, the left earphone, and the right earphone may be provided with magnetic materials, and the first Hall sensor, the second Hall sensor, and the third Hall sensor may all be located in the earphone compartment. The first Hall sensor is configured to detect a magnetic field strength between the upper cover and the earphone compartment, or the first Hall sensor is configured to detect a magnetic field strength of the upper cover. **In** the following embodiment, an example in which "the first Hall sensor is configured to detect a magnetic field strength between the upper cover and the earphone compartment" is used for description. The second Hall sensor and the third Hall sensor are respectively configured to detect a magnetic field strength between the left earphone and the earphone compartment and a magnetic field strength between the right earphone and the earphone compartment, or the second Hall sensor and the third Hall sensor are respectively configured to detect magnetic field strengths of the left earphone and the right earphone. In the following embodiment, an example in which "the second Hall sensor and the third Hall sensor are respectively configured to detect a magnetic field strength between the left earphone and the earphone compartment and a magnetic field strength between the right earphone and the earphone compartment" is used for description.

In some embodiments, the first Hall sensor may be further located at a snap-fit position between the upper cover and the earphone compartment, to detect the magnetic field strength between the upper cover and the earphone compartment. Positions at which the first Hall sensor, the second Hall sensor, and the third Hall sensor are disposed are not limited in embodiments of this application.

In some embodiments, in a scenario in which the electronic device is not electrically connected to a Hall sensor, for example, in a scenario in which the Hall sensor is disposed in an earphone case, but the earphone case is disposed independently of the electronic device, using the first Hall sensor as an example, the first Hall sensor may be wirelessly connected to the electronic device. A wireless connection may be a Bluetooth connection, a Wi-Fi connection, or the like. The first Hall sensor may send information to the electronic device by using a wireless connection channel between the first Hall sensor and the electronic device.

When detecting that the magnetic field strength meets a first predetermined condition, the first Hall sensor may send the information to the electronic device, so that the electronic device displays a user interface indicating that the cover is opened. Correspondingly, when detecting that the magnetic field strength meets a second predetermined condition, the first Hall sensor may send the information to the electronic device, so that the electronic device displays a user interface indicating that the cover is closed. When detecting that the magnetic field strength meets a third predetermined condition, the second Hall sensor and/or the third Hall sensor may send information to the electronic device, so that the electronic device displays a corresponding user interface indicating that the earphones are out of the case. When detecting that the magnetic field strength meets a fourth predetermined condition, the second Hall sensor and/or the third Hall sensor may send the information to the electronic device, so that the electronic device displays a corresponding user interface indicating that the earphones are in the case.

In some embodiments, in a scenario in which the electronic device is electrically connected to a Hall sensor, for example, when the earphone compartment is disposed in the electronic device and the Hall sensor is located in the earphone compartment, the electronic device may determine, by detecting the magnetic field strength using the Hall sensor, that the cover is opened or closed and that the earphones are out of the case or in the case. When the first Hall sensor detects that the magnetic field strength meets the first predetermined condition, the display on the upper cover of the electronic device may display a user interface indicating that the cover is opened. When the first Hall sensor detects that the magnetic field strength meets the second predetermined condition, the display on the upper cover of the electronic device may display a user interface indicating that the cover is closed. When the second Hall sensor or the third Hall sensor detects that the magnetic field strength meets the third predetermined condition, the display on the upper cover of the electronic device may display a corresponding user interface indicating that the earphones are out of the case. When the second Hall sensor or the third Hall sensor detects that the magnetic field strength meets the fourth predetermined condition, the display on the upper cover of the electronic device may display a corresponding user interface indicating that the earphones are in the case.

The magnetic field strength detected by the first Hall sensor falls within a first preset range, the magnetic field strength detected by the second Hall sensor falls within a second preset range, and the magnetic field strength detected by the third Hall sensor falls within a third preset range. The first preset range is different from the second preset range and the third preset range, and there is no intersection. The second preset range and the third preset range may be the same or different. The second preset range and the third preset range have no intersection under a condition that the second preset range and the third preset range are different.

The first predetermined condition may be that the magnetic field strength detected by the first Hall sensor is less than a first threshold, and the second predetermined condition may be that the magnetic field strength detected by the first Hall sensor is greater than the first threshold. The third predetermined condition may be that the magnetic field strength detected by the second Hall sensor is less than a second threshold and that the magnetic field strength detected by the third Hall sensor is less than a third threshold. The fourth predetermined condition may be that the magnetic field strength detected by the second Hall sensor is greater than the second threshold and that the magnetic field strength detected by the third Hall sensor is greater than the third threshold. The first threshold is different from the second threshold and the third threshold. When the second preset range is the same as the third preset range, the second threshold may be the same as the third threshold. When the second preset range is different from the third preset range, the second threshold may be different from the third threshold.

However, in a process in which the user uses the electronic device and the earphones, the following cases may occur.

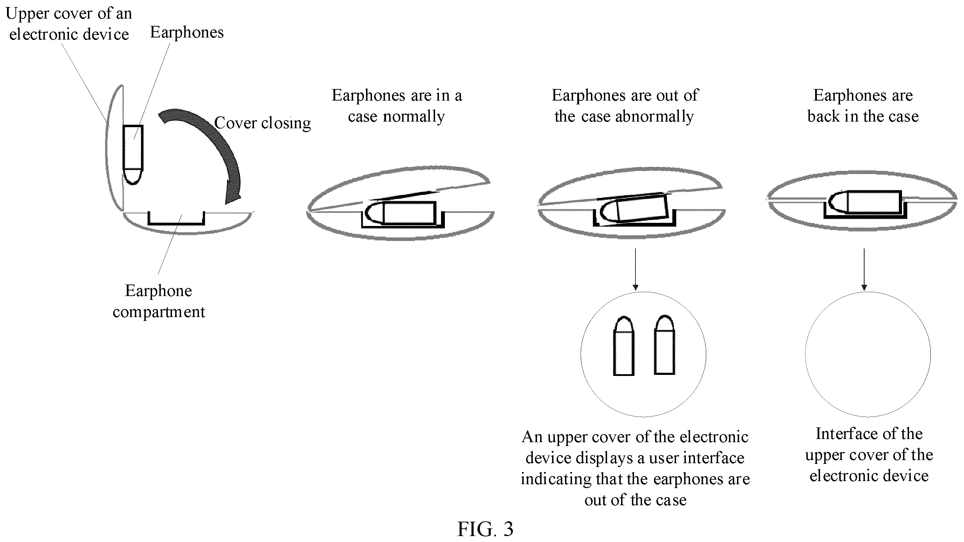

As shown in FIG. 3, when the upper cover is opened, the earphones are attached to the upper cover. In this case, in a process of snap-fitting the upper cover, if positions of the earphones in the upper cover do not directly face the accommodating cavities of the earphone compartment, the earphones may press against edges of the accommodating cavities and the earphones are detached from attachment positions in the upper cover. After entering the accommodating cavities, the earphones are attached back to the upper cover. In the foregoing process, the earphones are detached from the attachment positions in the upper cover and then are attached back to the upper cover, causing the display on the upper cover of the electronic device to display a user interface indicating that the earphones are out of the case. However, this action is essentially an in-case process of the earphones, bringing use inconvenience to the user.

Alternatively, when the user opens the upper cover, the earphones are out of the case, and the electronic device displays a user interface indicating that the earphones are out of the case. If the user closes and opens the upper cover back and forth, and the earphones are out of the case and in the case back and forth, the display on the upper cover of the electronic device continuously displays the user interface indicating that the earphones are out of the case, bringing use inconvenience to the user.

This application provides an earphone state detection method, so that an out-of-case state and an in-case state of earphones can be accurately determined, and an interface is correctly displayed based on the detected earphone state, thereby improving user experience.

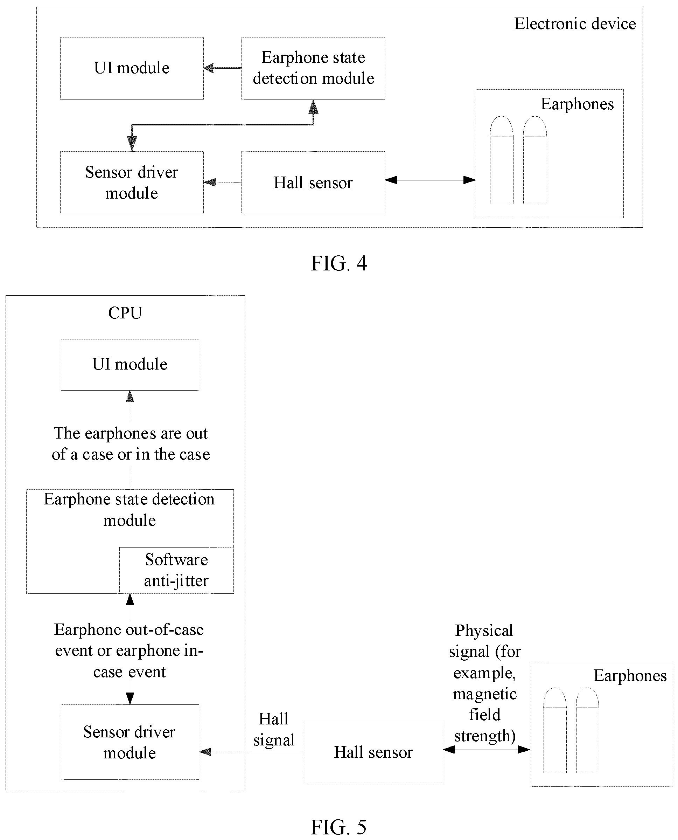

As shown in FIG. 4 and FIG. 5, when the accommodating apparatus is an electronic device, the electronic device may include a central processing unit (central processing unit, CPU) and a communication interface. For a function of the CPU, refer to related descriptions of the processor 110. In FIG. 4 and FIG. 5, an example in which the communication interface is a GPIO interface is used, and the GPIO interface is configured to implement communication between a Hall sensor and the CPU.

At a software layer, in some embodiments, the electronic device may include a sensor driver module, an earphone state detection module, and a UI module. In some embodiments, operations performed by the sensor driver module, the earphone state detection module, and the UI module may be considered as operations performed by the CPU.

In some embodiments, each Hall sensor may correspond to one GPIO interface, and the sensor driver module may be connected to each Hall sensor through the GPIO interface corresponding to each Hall sensor. The Hall sensor is, for example, a first Hall sensor, a second Hall sensor, or a third Hall sensor. In this embodiment, the second Hall sensor is used as an example. When detecting that a magnetic field strength meets a third predetermined condition or a fourth predetermined condition, the second Hall sensor may send a different Hall signal through a GPIO interface corresponding to the second Hall sensor, to represent that the second Hall sensor detects that the magnetic field strength meets the third predetermined condition or the fourth predetermined condition. The Hall signal is, for example, that the second Hall sensor pulls up a level value of the GPIO interface corresponding to the second Hall sensor to a preset level value. The different Hall signal may be: the second Hall sensor pulls up the level value of the GPIO interface corresponding to the second Hall sensor to different preset level values, so that the sensor driver module can determine, based on the Hall signal, that the earphones are out of the case or in the case.

In some embodiments, the sensor driver module may be connected to three Hall sensors through one GPIO interface. In this embodiment, when different Hall sensors detect that magnetic field strengths meet different predetermined conditions, different Hall signals may be sent through the GPIO interface, so that the sensor driver module can determine, based on the different Hall signals, that the cover is opened or closed and that the earphones are out of the case or in the case.

The sensor driver module may receive the Hall signal from the Hall sensor through the GPIO interface, and generate different events based on the Hall signal, for example, a cover opening event, a cover closing event, an earphone out-of-case event, or an earphone in-case event. The sensor driver module may report the event to the earphone state detection module. After performing software anti-jitter processing, the earphone state detection module may indicate the UI module to display an image showing that the cover is closed, an image showing that the cover is opened, an image showing that the earphones are out of the case, or an image showing that the earphones are in the case. This embodiment of this application focuses on a scenario in which the earphone state detection module indicates the UI module to display the image showing that the earphones are out of the case or the image showing that the earphones are in the case.

With reference to specific embodiments, the following describes the earphone state detection method provided in embodiments of this application. The following several embodiments may be combined with each other, and a same or similar concept or process may not be described repeatedly in some embodiments.

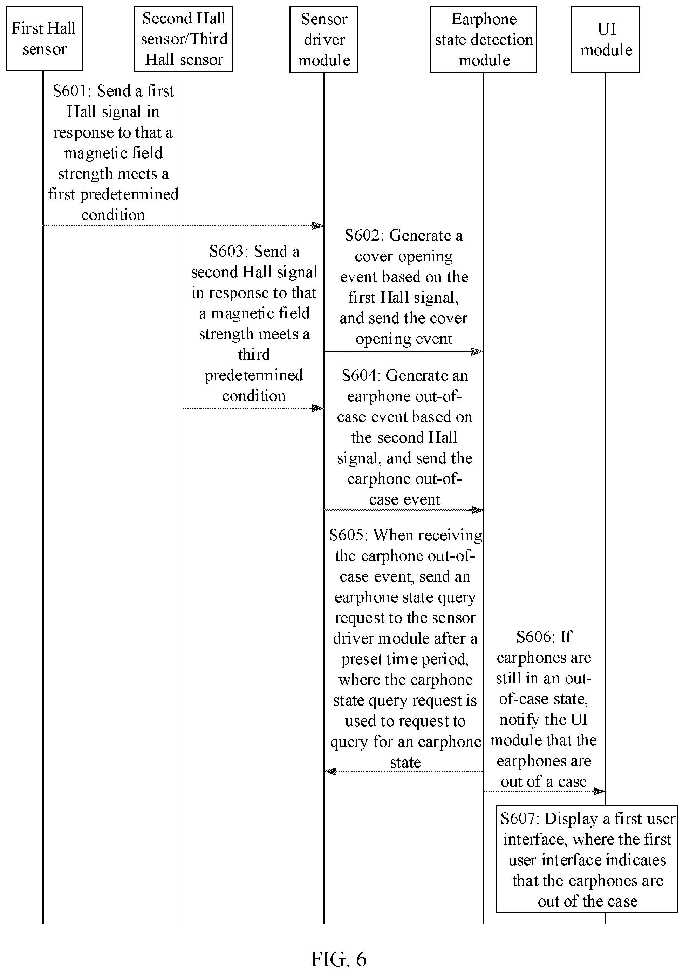

FIG. 6 is a schematic flowchart of an embodiment of an earphone state detection method according to an embodiment of this application. As shown in FIG. 6, in a scenario in which a user opens a cover and takes out earphones, earphone state detection provided in this embodiment of this application may include the following steps.

S601: A first Hall sensor sends a first Hall signal to a sensor driver module in response to that a magnetic field strength meets a first predetermined condition, where the first Hall signal represents that the magnetic field strength meets the first predetermined condition.

In a scenario in which the cover is opened, an upper cover of an electronic device is away from an earphone compartment. Therefore, a magnetic field strength between the upper cover and the earphone compartment becomes weaker. The first Hall sensor is configured to detect the magnetic field strength between the upper cover and the earphone compartment. When determining that the magnetic field strength is less than a first threshold, the first Hall sensor may determine that the cover is opened, and send the first Hall signal to the sensor driver module. The first Hall signal represents that the magnetic field strength meets the first predetermined condition, that is, represents that the cover is opened. For a manner in which the first Hall sensor sends the first Hall signal to the sensor driver module, refer to related descriptions in the foregoing embodiment.

S602: The sensor driver module generates a cover opening event based on the first Hall signal, and reports the cover opening event to an earphone state detection module.

The sensor driver module may determine, based on the first Hall signal, that the cover is opened, and then generate the cover opening event and report the cover opening event to the earphone state detection module. The cover opening event represents that the upper cover of the electronic device is opened, that is, the cover is opened.

In some embodiments, the earphone state detection module may send the cover opening event to a UI module. The UI module represents a service layer. In some embodiments, the UI module may display, in response to the cover opening event, a user interface representing that the cover is opened.

It should be understood that the sensor driver module may store the cover opening event until the event is updated.

In some embodiments, S601 and S602 may be considered as: The earphone state detection module determines whether the cover is opened. If receiving the cover opening event from the sensor driver module, the earphone state detection module determines that the cover is opened. If the earphone state detection module fails to receive the cover opening event from the sensor driver module, the earphone state detection module determines that the cover is not opened.

S603: The second Hall sensor sends a second Hall signal to the sensor driver module in response to that a magnetic field strength meets a third predetermined condition, where the second Hall signal represents that the magnetic field strength meets the third predetermined condition.

In the scenario in which the cover is opened, the earphones are attached to the upper cover. As the upper cover moves away from the earphone compartment (or accommodating cavities), the magnetic field strength between the earphones and the earphone compartment becomes weaker. The second Hall sensor is configured to detect the magnetic field strength between the earphones and the earphone compartment. When determining that the magnetic field strength is less than a second threshold, the second Hall sensor may determine that the earphones are out of a case, and send the second Hall signal to the sensor driver module. The second Hall signal represents that the magnetic field strength meets the third predetermined condition, that is, represents that the earphones are out of the case.

S604: The sensor driver module generates an earphone out-of-case event based on the second Hall signal, and reports the earphone out-of-case event to the earphone state detection module.

For S604, refer to related descriptions in S602.

A working principle of a third Hall sensor is the same as that of the second Hall sensor, and details are not described herein again.

In some embodiments, S603 and S604 may be considered as: The earphone state detection module determines whether the earphones are out of the case. If receiving the earphone out-of-case event from the sensor driver module, the earphone state detection module determines that the earphones are out of the case. If the earphone state detection module fails to receive the earphone out-of-case event from the sensor driver module, the earphone state detection module determines that the earphones are not out of the case.

S605: When receiving the earphone out-of-case event, the earphone state detection module sends an earphone state query request to the sensor driver module after a preset time period, where the earphone state query request is used to request to query for an earphone state.

After receiving the earphone out-of-case event, the earphone state detection module does not immediately notify the UI module that the earphones are out of the case, but continues to detect the earphone state within the preset time period. In this way, accuracy of the earphone state can be ensured. This can avoid inaccurate displaying of the upper cover of the electronic device caused by an unstable earphone state in a short time.

The earphone state detection module may start software anti-jitter logical judgment based on a time at which the earphone out-of-case event is received, that is, send the earphone state query request to the sensor driver module after the preset time period (for example, 150 ms), to detect the earphone state, that is, determine again whether the earphones are still in an out-of-case state.

S606: If the earphones are still in the out-of-case state, the earphone state detection module notifies the UI module that the earphones are out of the case.

S607: The UI module displays a first user interface, where the first user interface indicates that the earphones are out of the case.

The sensor driver module may store the earphone out-of-case event until the event is updated. After receiving the earphone state query request, the sensor driver module may send an event in the sensor driver module to the earphone state detection module. If the event in the sensor driver module is not updated, the sensor driver module sends the earphone out-of-case event to the earphone state detection module. The earphone state detection module may determine that the earphones are still in the out-of-case state. In this case, the earphone state detection module may notify the UI module that the earphones are out of the case. The UI module may display the first user interface in response to that the earphones are out of the case, and the first user interface indicates that the earphones are out of the case.

It should be understood that the first user interface and a second user interface in embodiments of this application may be collectively referred to as a user interface.

If the event in the sensor driver module is updated, for example, is updated to an earphone in-case event, the sensor driver module sends the earphone in-case event to the earphone state detection module. The earphone state detection module may determine that the earphones are in an in-case state. In this case, the earphone state detection module may not notify the UI module that the earphones are out of the case, and the UI module does not display the first user interface.

In this embodiment of this application, on a basis of detecting, by the second Hall sensor, that the earphones are out of the case, software logical judgment is added to the earphone state detection module, to filter out an abnormal signal triggered by hardware, thereby ensuring that a user interface indicating that the earphones are out of the case is displayed after the cover is opened and when the earphones are actually out of the case. The abnormal signal triggered by the hardware may be understood as: The earphones switch back and forth between the out-of-case state and the in-case state.

Refer to FIG. 6. An example in which the electronic device is a watch is used. The following describes an out-of-case process of the earphones.
1. The user opens the upper cover of the watch, and the earphones are attached to the upper cover under magnetic attraction of the magnetic apparatus of the upper cover, and are detached from the earphone compartment with movement of the upper cover.
2. When detecting that the magnetic field strength meets the first predetermined condition, the first Hall sensor sends the first Hall signal to a CPU through a GPIO interface; and
   when detecting that the magnetic field strength meets the third predetermined condition, the second Hall sensor sends the second Hall signal to the CPU through the GPIO interface. For example, the second Hall signal is that the second Hall sensor pulls up a level value of the GPIO interface to a high level, where a level value of the high level is greater than a level threshold.
3. After detecting the first Hall signal, the sensor driver module in the CPU generates the cover opening event, and sends the cover opening event to the earphone state detection module; and
   after detecting the second Hall signal, the sensor driver module in the CPU generates the earphone out-of-case event, and sends the earphone out-of-case event to the earphone state detection module.
4. The earphone state detection module starts software anti-jitter logical judgment based on a time at which the earphone out-of-case event is received, that is, sends the earphone state query request to the sensor driver module after the preset time period, to query for the earphone state.
5. If the earphone state is still the out-of-case state, the earphone state detection module notifies the UI module that the earphones are out of the case, and the UI module displays the first user interface. If the earphone state is not the out-of-case state, the earphone state detection module does not need to notify the UI module that the earphones are out of the case.
6. The UI module displays the first user interface, and the first user interface indicates that the earphones are out of the case.

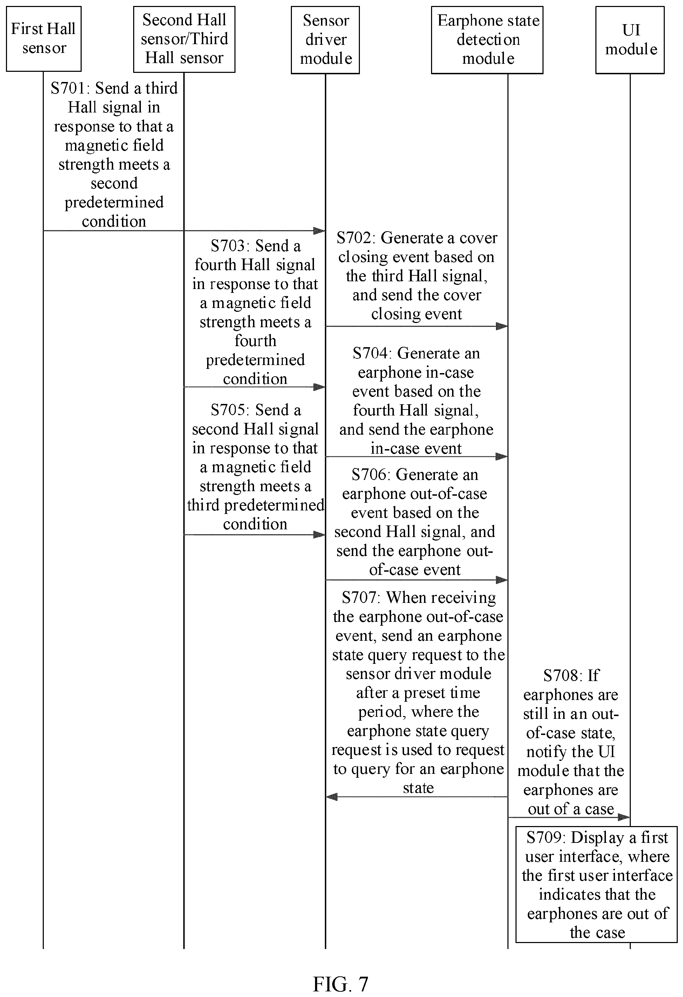

FIG. 7 is a schematic flowchart of another embodiment of an earphone state detection method according to an embodiment of this application. As shown in FIG. 7, in a scenario in which a user closes a cover and earphones are in a case, earphone state detection provided in this embodiment of this application may include the following steps.

S701: A first Hall sensor sends a third Hall signal to a sensor driver module in response to that a magnetic field strength meets a second predetermined condition, where the third Hall signal represents that the magnetic field strength meets the second predetermined condition.

In a scenario in which the cover is closed, an upper cover of an electronic device moves close to an earphone compartment. Therefore, a magnetic field strength between the upper cover and the earphone compartment becomes stronger. When determining that the magnetic field strength is greater than a first threshold, the first Hall sensor may determine that the cover is closed, and send the third Hall signal to the sensor driver module. The third Hall signal represents that the magnetic field strength meets the second predetermined condition, that is, represents that the cover is closed.

S702: The sensor driver module generates a cover closing event based on the third Hall signal, and reports the cover closing event to an earphone state detection module.

The sensor driver module may determine, based on the third Hall signal, that the cover is closed, and then generate the cover closing event and report the cover closing event to the earphone state detection module. The cover closing event represents that the upper cover of the electronic device is closed, that is, the cover is closed.

In some embodiments, the earphone state detection module may send the cover closing event to a UI module. In some embodiments, the UI module may display, in response to the cover closing event, a user interface representing that the cover is closed.

It should be understood that the sensor driver module may store the cover closing event until the event is updated.

In some embodiments, S701 and S702 may be considered as: The earphone state detection module determines whether the cover is closed. If receiving the cover closing event from the sensor driver module, the earphone state detection module determines that the cover is closed. If the earphone state detection module fails to receive the cover closing event from the sensor driver module, the earphone state detection module determines that the cover is not closed.

S703: The second Hall sensor sends a fourth Hall signal to the sensor driver module in response to that a magnetic field strength meets a fourth predetermined condition, where the fourth Hall signal represents that the magnetic field strength meets the fourth predetermined condition.

After using the wireless earphones, the user may place the earphones at corresponding positions in the upper cover and snap-fit the upper cover. In the scenario in which the cover is closed, the earphones are attached to the upper cover. As the upper cover moves close to the earphone compartment (or accommodating cavities), the magnetic field strength between the earphones and the earphone compartment becomes stronger. When determining that the magnetic field strength is greater than a second threshold, the second Hall sensor may determine that the earphones are in the case, and send the fourth Hall signal to the sensor driver module. The fourth Hall signal represents that the magnetic field strength meets the fourth predetermined condition, that is, represents that the earphones are in the case.

S704: The sensor driver module generates an earphone in-case event based on the fourth Hall signal, and reports the earphone in-case event to the earphone state detection module.

For S704, refer to related descriptions in S602.

A working principle of a third Hall sensor is the same as that of the second Hall sensor, and details are not described herein again.

In some embodiments, S603 and S604 may be considered as: The earphone state detection module determines whether the earphones are in the case. If receiving the earphone in-case event from the sensor driver module, the earphone state detection module determines that the earphones are in the case. If the earphone state detection module fails to receive the earphone in-case event from the sensor driver module, the earphone state detection module determines that the earphones are not in the case.

In an in-case process of the earphones, if positions of the earphones in the upper cover do not directly face the accommodating cavities of the earphone compartment, the earphones may press against edges of the accommodating cavities and the earphones are detached from attachment positions in the upper cover. After entering the accommodating cavities, the earphones are attached back to the upper cover. In this scenario, S705 and S706 are performed.

S705: The second Hall sensor sends a second Hall signal to the sensor driver module in response to that a magnetic field strength meets a third predetermined condition, where the second Hall signal represents that the magnetic field strength meets the third predetermined condition.

S706: The sensor driver module generates an earphone out-of-case event based on the second Hall signal, and reports the earphone out-of-case event to the earphone state detection module.

S707: When receiving the earphone out-of-case event, the earphone state detection module sends an earphone state query request to the sensor driver module after a preset time period, where the earphone state query request is used to request to query for an earphone state.

S708: If the earphones are still in an out-of-case state, the earphone state detection module notifies the UI module that the earphones are out of the case.

S709: The UI module displays a first user interface, where the first user interface indicates that the earphones are out of the case.

For S705 to S709, refer to related descriptions in S603 to S607.

It may be figured out that if the earphones are not in the out-of-case state, the earphone state detection module does not notify the UI module that the earphones are out of the case.

In an in-case process of the earphones, if positions of the earphones in the upper cover do not directly face the accommodating cavities of the earphone compartment, the earphones may press against edges of the accommodating cavities and the earphones are detached from attachment positions in the upper cover. After entering the accommodating cavities, the earphones are attached back to the upper cover. In addition, the earphones may enter the earphone compartment with movement of the upper cover, that is, the earphones are in an in-case state. In this scenario, the earphone state detection module detects that the earphones are not in the out-of-case state. In this case, the earphone state detection module does not notify the UI module that the earphones are out of the case. Correspondingly, the UI module does not display the first user interface.

In this embodiment of this application, on a basis of detecting that the earphones are out of the case by the second Hall sensor, software logical judgment is added to the earphone state detection module, to filter out an abnormal signal triggered by hardware, thereby ensuring that after the cover is closed, incorrect displaying of a user interface indicating that the earphones are out of the case caused by false detection is avoided. The abnormal signal triggered by the hardware may be understood as: The earphones are out of the case and then back in the case.

Refer to FIG. 7. An example in which the electronic device is a watch is used. The following describes an in-case process of the earphones.
1. The user closes the upper cover of the watch, and the earphones move close to the earphone compartment with movement of the upper cover.
2. When detecting that the magnetic field strength meets the second predetermined condition, the first Hall sensor sends the third Hall signal to a CPU through a GPIO interface; and
   when detecting that the magnetic field strength meets the fourth predetermined condition, the second Hall sensor sends the fourth Hall signal to the CPU through the GPIO interface. For example, the fourth Hall signal is that the second Hall sensor pulls a level value of the GPIO interface to a low level, where a level value of the low level is less than a level threshold.
3. After detecting the third Hall signal, the sensor driver module in the CPU generates the cover closing event, and sends the cover closing event to the earphone state detection module; and
   after detecting the fourth Hall signal, the sensor driver module in the CPU generates the earphone in-case event, and sends the earphone in-case event to the earphone state detection module.
4. In an in-case process of the earphones, if positions of the earphones in the upper cover do not directly face the accommodating cavities of the earphone compartment, the earphones may press against edges of the accommodating cavities and the earphones are detached from attachment positions in the upper cover. After entering the accommodating cavities, the earphones are attached back to the upper cover. In this scenario, when detecting that the magnetic field strength meets the third predetermined condition, the second Hall sensor sends the second Hall signal to the CPU through the GPIO interface. After detecting the second Hall signal, the sensor driver module in the CPU generates the earphone out-of-case event, and sends the earphone out-of-case event to the earphone state detection module.
5. The earphone state detection module starts software anti-jitter logical judgment based on a time at which the earphone out-of-case event is received, that is, sends the earphone state query request to the sensor driver module after the preset time period, to query for the earphone state.
6. If the earphone state is still the out-of-case state, the earphone state detection module notifies the UI module that the earphones are out of the case, and the UI module displays the first user interface. If the earphone state is not the out-of-case state, the earphone state detection module does not need to notify the UI module that the earphones are out of the case. In this embodiment of this application, after entering the accommodating cavities, the earphones are attached back to the upper cover, and then the earphones are back in the case as the user closes the cover. Therefore, the earphone state detection module detects that the earphones are not out of the case, and does not send the earphone out-of-case event to the UI module. Correspondingly, the UI module does not display the first user interface.

The foregoing embodiments describe a solution in which the earphone state detection module accurately determines, based on the software anti-jitter logical judgment, whether the earphones are out of the case in a scenario in which the cover is opened or closed. In some embodiments, in a scenario in which the cover is opened or closed, the earphone state detection module may further accurately determine, based on software anti-jitter logical judgment, whether the earphones are in the case. In this way, in a scenario in which the earphones are in the case, the UI module is notified that the earphones are in the case, so that the UI module displays a second user interface, where the second user interface represents that the earphones are in the case.

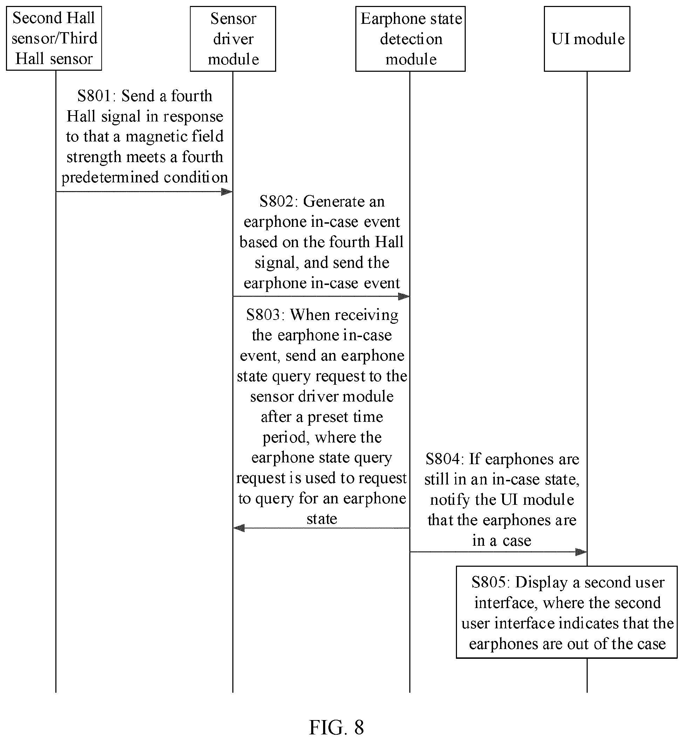

In a scenario in which the cover is opened or closed, as shown in FIG. 8, the earphone state detection method provided in this embodiment of this application may include the following steps.

S801: A second Hall sensor sends a fourth Hall signal to a sensor driver module in response to that a magnetic field strength meets a fourth predetermined condition, where the fourth Hall signal represents that the magnetic field strength meets the fourth predetermined condition.

The fourth Hall signal represents that the magnetic field strength meets the fourth predetermined condition, that is, represents that the earphones are in a case.

A working principle of a third Hall sensor is the same as that of the second Hall sensor, and details are not described herein again.

S802: The sensor driver module generates an earphone in-case event based on the fourth Hall signal, and reports the earphone in-case event to an earphone state detection module.

For S802, refer to related descriptions in S602.

In some embodiments, S801 and S802 may be considered as: The earphone state detection module determines whether the earphones are in the case. If receiving the earphone in-case event from the sensor driver module, the earphone state detection module determines that the earphones are in the case. If the earphone state detection module fails to receive the earphone in-case event from the sensor driver module, the earphone state detection module determines that the earphones are not in the case.

S803: When receiving the earphone in-case event, the earphone state detection module sends an earphone state query request to the sensor driver module after a preset time period, where the earphone state query request is used to request to query for an earphone state.

After receiving the earphone in-case event, the earphone state detection module does not immediately notify the UI module that the earphones are in the case, but continues to detect the earphone state within the preset time period. This can ensure accuracy of the earphone state, and can avoid inaccurate displaying of the upper cover of the electronic device caused by an inaccurate earphone state.

The earphone state detection module may start software anti-jitter logical judgment based on a time at which the earphone in-case event is received, that is, send the earphone state query request to the sensor driver module after the preset time period (for example, 150 ms), to detect the earphone state, that is, determine again whether the earphones are still in an in-case state.

S804: If the earphones are still in an in-case state, the earphone state detection module notifies the UI module that the earphones are in the case.

S805: The UI module displays a second user interface, where the second user interface indicates that the earphones are in the case.

If the earphones are not in the in-case state, the earphone state detection module does not notify the UI module that the earphones are in the case.

For S804 and S805, refer to related descriptions in S606 and S607.

In this embodiment of this application, in a scenario in which the cover is opened or closed, the earphone state detection module may further accurately determine, based on software anti-jitter logical judgment, whether the earphones are in the case. In this way, in a scenario in which the earphones are actually in the case, the UI module is notified that the earphones are in the case, so that the UI module displays the second user interface, where the second user interface represents that the earphones are in the case.

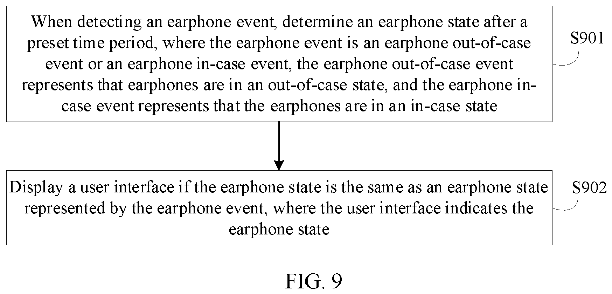

In conclusion, refer to FIG. 9. The earphone state detection method provided in this embodiment of this application may include the following steps.

S901: When detecting an earphone event, determine an earphone state after a preset time period, where the earphone event is an earphone out-of-case event or an earphone in-case event, the earphone out-of-case event represents that earphones are in an out-of-case state, and the earphone in-case event represents that the earphones are in an in-case state.

The earphone event is the earphone out-of-case event or the earphone in-case event. The earphone out-of-case event represents that the earphones are in the out-of-case state, and the earphone in-case event represents that the earphones are in the in-case state.

S902: Display a user interface if the earphone state is the same as an earphone state represented by the earphone event, where the user interface indicates the earphone state.

For example, if the earphone event is the earphone out-of-case event, and the earphone state determined after the preset time period is still the out-of-case state, a first user interface may be displayed, and the first user interface indicates that the earphones are out of a case. If the earphone event is the earphone in-case event, and the earphone state determined after the preset time period is still the in-case state, a second user interface may be displayed, and the second user interface indicates that the earphones are in the case.

An implementation principle of the earphone state detection method provided in this embodiment of this application is the same as principles of embodiments shown in FIG. 6, FIG. 7, and FIG. 8. For details, refer to descriptions of the foregoing embodiments.

In some embodiments, a UI module may further display different user interfaces based on a quantity of earphones that are out of a case or in the case.

For example, a second Hall sensor and a third Hall sensor may respectively detect whether a left earphone and a right earphone are out of the case or in the case. Correspondingly, a sensor driver module may generate a corresponding event based on Hall signals from the second Hall sensor and the third Hall sensor. If the sensor driver module receives a Hall signal from the second Hall sensor, but fails to receive the Hall signal from the third Hall sensor, the sensor driver module may generate an out-of-case event of a single earphone or an in-case event of a single earphone, and report the out-of-case event of the single earphone or the in-case event of the single earphone to an earphone state detection module. When receiving the out-of-case event of the single earphone or the in-case event of the single earphone, the earphone state detection module waits preset duration and sends an earphone state query request to the sensor driver module, to detect whether the single earphone is still in an out-of-case state or an in-case state. If the single earphone is still in the out-of-case state, the earphone state detection module sends the out-of-case event of the single earphone to the UI module, and the UI module displays a user interface representing that the single earphone is out of the case. If the single earphone is still in the in-case state, the earphone state detection module sends the in-case event of the single earphone to the UI module, and the UI module displays a user interface representing that the single earphone is in the case.

Similarly, if two earphones are out of the case or in the case, the UI module displays a user interface representing that the two earphones are out of the case, or displays a user interface representing that the two earphones are in the case.

In this embodiment of this application, different user interfaces are displayed based on a quantity of earphones that are out of the case or in the case, thereby enriching interface display and improving user experience.

The implementations of this application may be randomly combined, to achieve different technical effects.

In an implementation process, steps in the foregoing methods can be implemented by using a hardware integrated logic circuit in the processor, or by using instructions in a form of software. The steps of the method disclosed with reference to embodiments of this application may be directly performed by a hardware processor, or may be performed by using a combination of hardware in the processor and a software module. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor. To avoid repetition, details are not described herein again.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

All or some of the foregoing embodiments may be implemented by using software, hardware, firmware, or any combination thereof. When software is used to implement embodiments, the foregoing embodiments may be implemented completely or partially in a form of a computer program product. The computer program product includes one or more computer instructions. When the computer program instructions are loaded and executed on the computer, the procedures or functions according to embodiments of this application are completely or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, DVD), a semiconductor medium (for example, a solid-state disk Solid State Disk (SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

It should be understood that descriptions of technical features, technical solutions, advantages, or similar statements in this specification do not imply that all features and advantages can be implemented in any individual embodiment. In contrast, it may be understood that descriptions of the features or advantages mean that a particular technical feature, technical solution, or advantage is included in at least one embodiment. Therefore, the descriptions of the technical features, technical solutions, or advantages in this specification do not necessarily indicate a same embodiment. Further, the technical features, technical solutions, and advantages described in the following embodiments may be combined in any proper manner. A person skilled in the art should understand that an embodiment may be implemented without one or more particular technical features, technical solutions, or advantages of a particular embodiment. In other embodiments, an additional technical feature and advantage may be identified in a particular embodiment that does not embody all embodiments.

## Claims

1. An earphone state detection method, comprising:
when detecting an earphone event, determining an earphone state after a preset time period, wherein the earphone event is an earphone out-of-case event or an earphone in-case event, the earphone out-of-case event represents that an earphone is in an out-of-case state, and the earphone in-case event represents that the earphone is in an in-case state; and
displaying a user interface if the earphone state is the same as an earphone state represented by the earphone event, wherein the user interface indicates the earphone state.

2. The method according to claim 1, wherein the earphone out-of-case event is an out-of-case event of a single earphone or an out-of-case event of a plurality of earphones, the out-of-case event of the single earphone represents that the single earphone is in the out-of-case state, and the out-of-case event of the plurality of earphones represents that the plurality of earphones are in the out-of-case state; and
the earphone in-case event is an in-case event of the single earphone or an in-case event of the plurality of earphones, the in-case event of the single earphone represents that the single earphone is in the in-case state, and the in-case event of the plurality of earphones represents that the plurality of earphones are in the in-case state.

3. The method according to claim 1 or 2, wherein before the detecting an earphone event, the method further comprises:
detecting a cover opening event or a cover closing event.

4. The method according to claim 1, wherein the earphone state detection method is applied to an electronic device, the electronic device comprises a first Hall sensor and a central processing unit CPU, the first Hall sensor is configured to detect that a cover is opened or closed, and the method comprises:
sending a first Hall signal to the CPU when the first Hall sensor detects that the cover is opened;
generating, by the CPU, the cover opening event based on the first Hall signal;
sending a third Hall signal to the CPU when the first Hall sensor detects that the cover is closed; and
generating, by the CPU, the cover closing event based on the third Hall signal.

5. The method according to claim 1, wherein the earphone state detection method is applied to an electronic device, the electronic device comprises a second Hall sensor, a third Hall sensor, and a central processing unit CPU, and the second Hall sensor and the third Hall sensor are configured to detect that the earphone is out of a case or in the case; and
the detecting an earphone event comprises:
sending a second Hall signal to the CPU when the second Hall sensor and the third Hall sensor detect that the earphone is out of the case;
generating, by the CPU, the earphone out-of-case event based on the second Hall signal;
sending a fourth Hall signal to the CPU when the second Hall sensor and the third Hall sensor detect that the earphone is in the case; and
generating, by the CPU, the earphone in-case event based on the fourth Hall signal.

6. The method according to claim 5, wherein the CPU comprises a sensor driver module, an earphone state detection module, and a user interface UI module, and the generating the earphone out-of-case event comprises:
receiving, by the sensor driver module, the second Hall signal, and generating the earphone out-of-case event based on the second Hall signal; and
the displaying a user interface comprises:
sending, by the sensor driver module, the earphone out-of-case event to the earphone state detection module;
when receiving the earphone out-of-case event, sending, by the earphone state detection module, an earphone state query request to the sensor driver module after the preset time period, wherein the earphone state query request is used to request to query for the earphone state;
sending, by the earphone state detection module, the earphone out-of-case event to the UI module if the found earphone state is still the earphone out-of-case state; and
displaying, by the UI module, the user interface indicating that the earphone is out of the case.

7. The method according to claim 5, wherein the CPU comprises a sensor driver module, an earphone state detection module, and a user interface UI module, and the generating the earphone in-case event comprises:
receiving, by the sensor driver module, the fourth Hall signal, and generating the earphone in-case event based on the fourth Hall signal; and
the displaying a user interface comprises:
sending, by the sensor driver module, the earphone in-case event to the earphone state detection module;
when receiving the earphone in-case event, sending, by the earphone state detection module, an earphone state query request to the sensor driver module after the preset time period, wherein the earphone state query request is used to request to query for the earphone state;
sending, by the earphone state detection module, the earphone in-case event to the UI module if the found earphone state is still the earphone in-case state; and
displaying, by the UI module, the user interface indicating that the earphone is in the case.

8. An electronic device, comprising a processor and a memory, wherein
the memory stores computer instructions; and
the processor executes the computer instructions stored in the memory, so that the processor performs the method according to any one of claims 1 to 7.

9. A computer-readable storage medium, wherein the computer-readable storage medium stores a computer program or instructions, and when the computer program or the instructions are run, the method according to any one of claims 1 to 7 is implemented.
